# EUROPÄISCHE PATENTSCHRIFT

(11) **EP 0 673 118 B1**
(45) Veröffentlichungstag und Bekanntmachung des Hinweises auf die Patenterteilung: **04.08.1999**
(21) Anmeldenummer: 95103375.2
(22) Anmeldetag: 09.03.1995
(51) Int. Cl.: H03K 19/0175

(54) **BiCMOS-Pegelwandler ECL-CMOS**
ECL to CMOS level converter of BiCMOS type
Convertisseur de niveau ECL en CMOS de type BiCMOS

(30) Priorität: 18.03.1994 DE 4409453
(43) Veröffentlichungstag der Anmeldung: 20.09.1995
(73) Patentinhaber: DEUTSCHE THOMSON-BRANDT GMBH, 78048 Villingen-Schwenningen (DE)
(72) Erfinder: Rau, Martin, D-89075 Ulm (DE)

(56) Entgegenhaltungen:
- EP-A- 0 435 335
- JP-A- 61 018 219
- US-A- 5 089 724
- US-A- 5 214 328

## Beschreibung

Die Erfindung betrifft eine Schaltung zur Verstärkung von Digitalsignalen mit einem kleinen logischen Pegelhub entsprechend der emittergekopptelten Transistor-Logik, im folgenden ECL genannt, auf einen großen in der CMOS-Logik gebräuchlichen Pegelhub.

Derartige Pegelverstärker werden als Pegelwandler benötigt bei der Kombination von ECL- und CMOS-Gattern auf einem Chip. Diese Technologie bietet bekannterweise die Möglichkeit, zeitkritische Signalpfade mit der schnellen ECL-Logik zu realisieren. Für die langsameren Schaltungsabschnitte verwendet man CMOS, um Chipfläche und Leistung zu sparen. Da beide Schaltungstechniken mit unterschiedlichen Signalpegeln arbeiten, benötigt man für einen gemischten Entwurf schnelle Pegelwandler. Dabei ist insbesondere die Verstärkung der kleinen ECL-Signale auf CMOS-Pegel schwierig. Sie ist auch bei der Realisierung von RAM-Speicherelementen ein zeitkritisches Kriterium.

Bei einer bekannten, als schneller digitaler Pegelwandler arbeitenden Verstärkerschaltung erfolgt die Spannungsverstärkung mit einer als Differenzverstärker mit bipolaren Transistoren ausgebildeten Eingangsstufe, die ihrerseits auf den Eingang der in CMOS-Technologie ausgeführten Ausgangsstufe des Pegelwandlers arbeitet. Die Signalverzögerungszeit, d.h. die Zeitspanne zwischen der Umschaltung zwischen H(High)- und L(Low)-Pegel am Eigang und am Ausgang, wird dabei von der Ruhestromaufnahme beeinflußt und ist näherungsweise umgekehrt proportional zur Leistungsaufnahme. Dabei dominiert die letzte bzw. die Ausgangsstufe, in der beim hohen Ausgangspegel ein großer statischer Querstrom fließt, hinsichtlich des Leistungsverbrauchs und hinsichtlich der Signalverzögerung.

Es ist Aufgabe der Erfindung, die Verzögerungszeiten eines derartigen Pegelwandlers zu reduzieren.

Aus der JP-A 61 018 219 in Patent Abstracts of Japan ist eine als Pegelwandler betriebene Verstärkerschaltung mit den Merkmalen gemäß Oberbegriff des unabhängigen Anspruches 1 bekannt.

Die oben genannte Aufgabe wird durch die im Anspruch 1 angegebene Erfindung gelöst. Vorteilhafte Weiterbildungen der Erfindung sind in den abhängigen Ansprüchen angegeben.

Der Erfindung liegt die Idee zugrunde, bei einer derartigen, als ECL-CMOS Pegelwandler betriebenen Verstärkerschaltung deren als Gegentaktverstärkerstufe ausgebildete Ausgangsstufe mittels komplementärer bipolarer Transistoren zu realisieren, obwohl jeder dieser Transistoren nach seinem Umschalten in die Sättigung gesteuert wird, wodurch sich zwar die jeweilige Einschaltzeit verkürzt, die Abschaltzeit jedoch wesentlich erhöht wird.

Hierbei werden die Signaleingänge der als Gegentaktverstärkerstufe geschalteten bipolaren Ausgangstransistoren mit dem jeweiligen Ausgangsstrom der als Differenzverstärker ausgebildeten Eingangsstufe im wesentlichen direkt gesteuert. Die Steuerung erfolgt dabei derart, daß von einer Stromansteuerung der beiden Ausgangstransistoren gesprochen werden kann.

Die Erfindung hat den Vorteil, daß im Vergleich mit dem bekannten Pegelwandler kein zusätzlicher Leistungsverbrauch erforderlich ist.

Die Erfindung wird nachfolgend anhand von Zeichnungen näher erläutert.

Es zeigen:
- Fig. 1: Prinzipschaltbild eines ersten Ausführungsbeispiels eines erfindungsgemäßen digitalen Pegelwandlers,
- Fig. 2: Prinzipschaltbild eines zweiten Ausführungsbeispiels des erfindungsgemäßen digitalen Pegelwandlers,
- Fig. 3: Prinzipschaltbild eines bekannten digitalen Pegelwandlers.

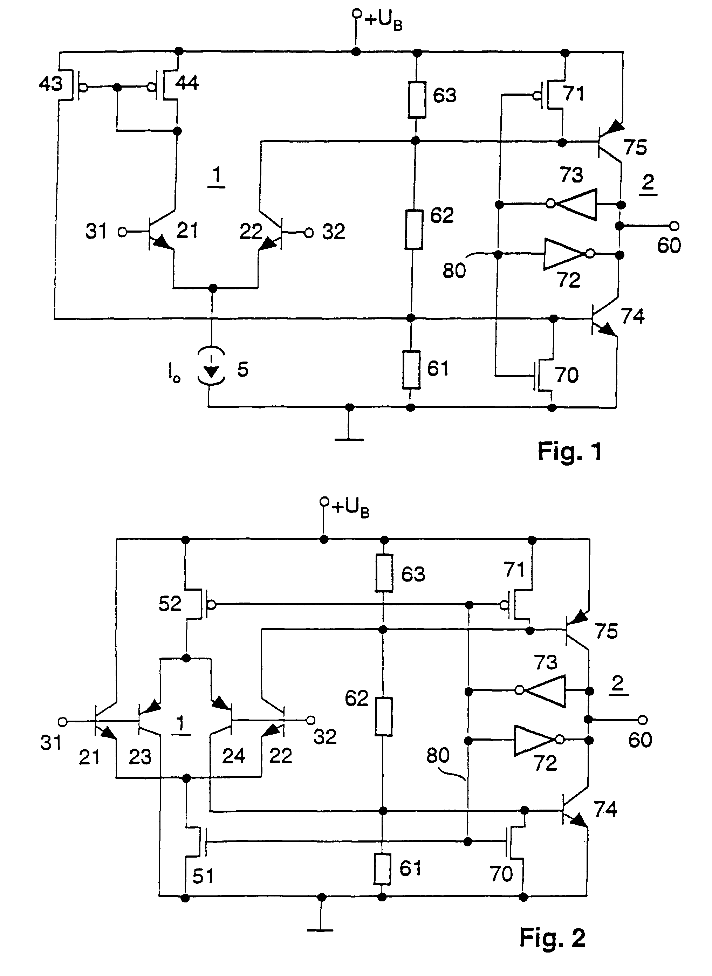

Es sei noch daraufhingewiesen, daß in den Figuren 1 bis 3 einander entsprechende Schaltungsteile mit den gleichen Bezugszeichen versehen sind.

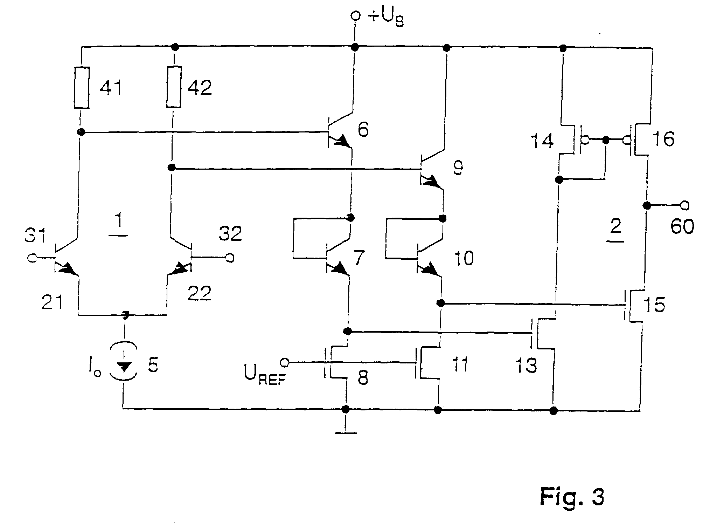

Fig. 3 zeigt ein Prinzipschaltbild eines bekannten digitalen Pegelwandlers mit einer Eingangsverstärkerstufe 1 und mit einer als Gegentaktverstärker ausgebildeten Ausgangsstufe 2, die einen P-Kanal-MOS-Transistor 16, dessen Sourceanschluß mit einer positiven Betriebsspannung +UB verbunden ist, sowie einen N-Kanal MOS-Transistor 15 aufweist, dessen Sourceanschluß mit dem Bezugspotential (Masse) der positiven Betriebsspannung +UB verbunden ist. Die Drainanschlüsse der beiden Ausgangstransistoren 15 und 16 sind miteinander verbunden und bilden dabei den Ausgang 60 des Pegelwandlers.

Die Eingangsstufe 1 besteht im wesentlichen aus einem Differenzverstärker aus bipolaren emittergekoppelten Transistoren 21 und 22, der mit einer an Masse angeschlossenen Konstantstromquelle 5 in Reihe geschaltet ist. Der jeweilige Basisanschluß der beiden Transistoren 21, 22 dient dabei als Eingang 31, 32 des Pegelwandlers. Der jeweilige Kollektoranschluß der beiden Transistoren 21, 22 ist über je einen Widerstand 41, 42 mit der positiven Betriebsspannung +UB verbunden, wobei die beiden Widerstände 41 und 42 die Arbeitswiderstände des Differenzverstärkers bilden.

Die beiden Eingänge 31, 32 können differentiell oder einseitig mit einer Referenzspannung an einem der Eingänge 31, 32 angesteuert werden. Damit mit dem Differenzverstärker eine entsprechende Spannungsverstärkung des relativ kleinen Pegelhubes des den Eingängen 31 und 32 zugeführten ECL-Signals durchgeführt werden kann, ohne daß die Transistoren dabei gesättigt werden, ist in nicht dargestellten vorgeschalteten Emitterfolgestufen der Signalpegel gegenüber der üblichen ECL-Konvention um eine oder zwei Diodenspannungen (von je ca. 0,8 Volt) abgesenkt.

Die Ansteuerung des Signaleinganges der beiden Ausgangstransistoren 15 und 16 erfolgt im wesentlichen über je eine Emitterfolgerstufe. Diese Emitterfolgerstufen werden mit je einem bipolaren Transistor 6, 9 gebildet, deren jeweiliger Kollektor mit der positiven Betriebsspannung +UB verbunden ist und deren jeweiliger Emitter über eine Reihenschaltung aus einem als Diode geschalteten Transistor 7, 10 und einer Konstantstromquelle 8, 11 mit Masse verbunden ist. Die Konstantstromquellen 8, 11 werden durch je einen N-Kanal MOS-Transistor gebildet, dessen jeweiliger Sourceanschluß mit Masse verbunden ist. Die Signalzuführung zum Gate-Anschluß der Ausgangstransistors 15 erfolgt dabei in direkter Weise vom Verbindungspunkt des Drainanschlußes des Transistors 11. Die Signalzuführung zum Gate-Anschluß des anderen Ausgangstransistors 6 erfolgt dagegen vom Verbindungspunkt des Drainanschlußes des Transistors 8 über einen N-Kanal MOS-Transistor 13. Dessen Drainanschluß ist zum einen mit dem Gate-Anschluß des Ausgangstransistors 16 verbunden und zum anderen über einen P-Kanal MOS-Transistor 14 mit der positiven Betriebsspannung +UB, dessen Drain und Gate kuzgeschlossen sind. Der Drainstrom von Transistor 13 wird über den aus Transistor 14 und 16 gebildeten gebildeten Stromspiegel zum Ausgang 60 übertragen.

Fig. 1 zeigt ein Prinzipschaltbild eines ersten Ausführungsbeispiels eines erfindungsgemäßen Pegelwandlers mit einer Eingangsverstärkerstufe 1 und mit einer als Gegentaktverstärker ausgebildeten Ausgangsstufe 2 aus einem bipolaren PNP-Transistor 75, dessen Emitteranschluß mit einer positiven Betriebsspannung +UB verbunden ist und aus einem bipolaren NPN-Transistor, dessen Emitteranschluß mit Masse verbunden ist. Die miteinander verbundenen Kollektoranschlüsse der beiden Transistoren 74 und 75 bilden dabei den Ausgang 60 des Pegelwandlers.

Die Eingangsstufe 1 unterscheidet sich von der des zuvor beschriebenen bekannten Pegelwandlers im wesentlichen dadurch, daß mit dem Ausgangsstrom des Transistors 22 im Differenzverstärker der Eingangsverstärkerstufe 1 der PNP-Ausgangstransistor 75 direkt angesteuert wird, während der technologiebedingt schnellere NPN-Ausgangstransistor 74 über einen Stromspiegel mit dem Ausgangsstrom des Transistors 21 angesteuert wird. Der Stromspiegel wird beispielhaft mit zwei P-Kanal MOS-Transistoren 43 und 44 gebildet, wobei bei dem zwischen Kollektoranschluß des Differenzverstärkertransistors 21 und der positiven Betriebsspannung +UB liegenden MOS-Transistor 44 der Drainanschluß mit den beiden Gate-Anschlüssen verbunden ist.

Zum jeweiligen Eingang der beiden bipolaren Ausgangstransistoren 74 und 75 ist jeweils ein Transistor 71, 70 parallel geschaltet. Diese beiden Transistoren 71 und 70 sind beispielhaft als MOS-Transistoren realisiert, wobei der Transistor 71, der dem Ausgangstransistor 75 zugeordnet ist, ein P-Kanal MOS-Transistor ist und der dem Ausgangstransistor 74 zugeordnete Transistor 70 ein N-Kanal MOS-Transistor ist. Die beiden Gate-Anschlüsse der beiden Transistoren 70, 71 sind miteinander verbunden sowie durch eine Parallelschaltung aus zwei gegeneinander geschalteten Invertern 72 und 73, deren Funktion später beschrieben ist, mit dem Ausgang 60 des Pegelwandlers verbunden. Für die Basis-Emitterspannungserzeugung der bipolaren Ausgangstransistoren 74, 75 im Wartezustand ist ein zwischen Masse und der positiven Betriebsspannung +UB angeordneter Spannungsteiler aus ohmschen Widerständen 61, 62, 63 vorgesehen. Die Arbeitsweise der soweit beschriebenen digitalen Verstärkerschaltung wird nachfolgend beschrieben.

Der von der Eingangsverstärkerstufe 1 umgeschaltete Strom steuert die komplementären bipolaren Ausgangstransistoren 70, 75 der Ausgangsstufe. Dabei wird der PNP-Ausgangstransistor 75 direkt und der technologiebedingt schnellere NPN-Ausgangstransistor 74 über den Stromspiegel angesteuert, so daß sich etwa gleiche Schaltzeiten für die steigende und die fallende Signalflanke des Ausgangssignals 60 erzielen lassen. Dieses Aussteuerungsprinzip ermöglicht das schnelle Umschalten des Ausgangs 60, da ein großer Strom für den schnellen Aufbau der Basisladung in den Ausgangstransistoren 74, 75 sorgt, und somit schnell ein großer Kollektorstrom fließen kann. Allerdings befindet sich jeder Ausgangstransistor 74, 75 nach dem Umschalten in Sättigung. Deshalb übernimmt der jeweilige zum entsprechenden Ausgangstransistor 74, 75 parallelgeschaltete MOS-Transistor 70, 71 nach dem Umschalten des Ausgangs 60 den Steuerstrom des jeweiligen bipolaren Ausgangstransistor 74, 75. Die MOS-Transistoren 70, 71 schalten auch die Basis-Emitter-Strecke des jeweiligen Ausgangstransistors 74, 75 kurz, so daß diese nur während der Signalflanke kurzzeitig gesättigt werden. Durch die volle Aussteuerung der bipolaren Ausgangstransistoren 74 und 75 erreicht der Ausgang 60 nahezu die Versorgungsspannungen bzw. nahezu die volle Versorgungsspannung +UB und das Massepotential.

Die Umschaltung der beiden bipolaren Ausgangstransistoren 74, 75 unter Mitwirkung der beiden zum jeweiligen Eingang parallel geschalteten MOS-Transistoren 70, 71 wird nachfolgend näher beschrieben: Dabei wird zunächst angenommen, daß sich der Ausgang 60 auf H-Potential befindet. Dann befindet sich die Verbindung 80 der beiden Gate-Ahschlüsse der Transistoren 70, 71 aufgrund des Inverters 73 auf L-Potential. Dabei wirkt der Inverter 72 unterstützend in der Weise auf den Ausgang 60, daß an diesem ein logischer Signalpegel auch über eine längere Zeit gehalten werden kann, da die Ausgangstransistoren 74, 75 nur während der Signalflanke aktiv sind.

Wird nun umgeschaltet, wird im Umschaltmoment der NPN-Ausgangstransistor 74 über den Stromspiegel einen Basisstrom zugeführt bekommen, der dazu führt, daß durch den Ausgangstransistor 74 ein großer Kollektorstrom fließt, der wesentlich größer als der Strom vom Inverter 72 ist, so daß der Inverter 72 beim Umschalten praktisch ohne Einfluß ist und der Ausgang 60 sehr schnell von High nach Low wechseln kann. Alle am Ausgang 60 angeschlossenen, nicht dargestellten Kapazitäten können somit schnell umgeladen werden, wobei der Strom des Inverters 72 vernachlässig gering ist.

Wenn sich das Potential des Ausgang 60 deutlich zum L-Pegel hin bewegt hat, dann schaltet der Inverter 73 um, was dazu führt, daß sich das Potential der Verbindungleitung 80 in Richtung H-Pegel verschiebt. Dieses bewirkt, daß der parallel zum Eingang des NPN-Ausgangstransistors 74 geschaltete Transistor 70 leitend wird und den vom Stromspiegel gelieferten Strom direkt nach Masse abführt, was dann dazu führt, daß der NPN-Ausgangstransistor 74 aus dem gesättigten Betriebszustand geführt und gesperrt wird. Bis zur nächsten Signalflanke hält nun der Inverter 72 das Ausgangspotential. Das gleiche gilt selbstverständlich entsprechend für den PNP-Ausgangstransistor 75, wenn der Ausgang 60 von Low auf High geschaltet wird.

Fig. 2 zeigt als zweites Ausführungsbeispiel eine Variante der als Pegelwandler verwendeten digitalen Verstärkerschaltung nach Fig. 1.

In dieser Schaltung erfolgt die Ansteuerung der beiden bipolaren komplementären Ausgangstransistoren 74 und 75 durch eine Eingangsverstärkerstufe 1, die durch zwei parallelgeschaltete komplementäre Differenzverstärker realisiert ist. Dabei wird jeder Differenzverstärker durch ein emittergekoppeltes bipolares Transistorpaar 21, 22; 23, 24 gebildet welches jeweils nur für die Ansteuerung eines der beiden Ausgangstransistoren 74; 75 zuständig ist.

Dadurch wird nach dem Umschalten des Ausgangs 60 des Pegelwandlers der jeweilige die Umschaltung auslösende Differenzverstärker nicht mehr benötigt, so daß der jeweilige bis zur nächsten Umschaltung nicht mehr benötigte Differenzverstärker vom Ausgang 60 aus über eine Rückkopplung mit dem Inverter 73 und eine mit dem jeweiligen emittergekoppelten Transistorpaar 21, 22; 23, 24 in Reihe geschaltete gesteuerte Stromquelle 51; 52 abgeschaltet werden kann.

Durch diese wechselweise Abschaltung der parallelgeschalteten komplementären Differenzverstärker der Eingangsstufe 1 verbraucht diese Schaltung noch weniger Leistung als die in Fig. 1 gezeigte, da der dort während des niedrigen Ausgangspegels bzw. Low-Pegels fließende gespiegelte Strom in dieser Schaltung entfällt. Die beiden Stromquellen 51, 52 sind beispielhaft mit MOS-Transistoren realisiert, wobei der dem emittergekoppelten Transistorpaar 21, 22 zugeordnete Transistor 51 ein N-Kanal MOS-Transistor ist und der dem emittergekoppelten Transistorpaar 23, 24 zugeordnete Transistor 52 ein P-Kanal MOS-Transistor ist.

Der jeweilige zum Eingang eines Ausgangstransistors 74, 75 parallel geschaltete MOS-Transistor 70, 71 kann dadurch kleiner dimensioniert werden, da er keinen statischen Strom mehr führt. Damit wird die parasitäre Kapazität an den Basisanschlüssen der Ausgangstransistoren 74, 75 geringer und beim Einschalten fließt mehr Strom in die Basis. Außerdem ist nun die Basis-Emitter-Restspannung sehr klein und der jeweilige abgeschaltete Ausgangstransistor 74, 75 wird während der Flanke am Ausgang 60 durch die parasitäre Basis-Kollektor-Kapazität nicht mehr kurzzeitig leitend. Deshalb arbeitet diese Schaltung noch schneller als die in Fig. 1 gezeigte.

Die in Fig. 1 und 2 gezeigten Schaltungen sind insbesondere zur Pegelwandlung bzw. -anpassung an den Übergängen zwischen ECL- und CMOS-Schaltungen anwendbar. Eine weitere bedeutende Anwendung ist deren Verwendung als digitaler Verstärker zum Auslesen von Informationen innerhalb RAM-Bausteinen.

## Patentansprüche

1. Elektronische Schaltung zur Verstärkung von Digitalsignalen mit einem kleinen in der emittergekoppelten Transistor-Logik gebräuchlichen Pegelhub auf einen großen in der CMOS-Logik gebräuchlichen Pegelhub mit einer als Differenzverstärker ausgebildeten Eingangsstufe (1), deren Steuereingängen die auf den großen Pegelhub zu verstärkenden Digitalsignale mit dem kleinen Pegelhub zugeführt werden und mit einer von der Eingangsstufe (1) angesteuerten, mittels komplementärer bipolarer Transistoren (74, 75) als Gegentaktverstärker ausgebildeten Ausgangsstufe (2), an deren Ausgang (60) das auf den großen Pegelhub verstärkte Digitalsignal abnehmbar ist, wobei die Basis-Anschlüsse der komplementären bipolaren Transistoren (74, 75) Steuereingänge der Ausgangsstufe (2) bilden und mindestens einer dieser Transistoren (75) durch den durch die Eingangsdifferenzverstärkerstufe (1) umgeschalteten Strom direkt angesteuert wird, und wobei den Basis-Emitter-Strecken der beiden komplementären bipolaren Transistoren (74, 75) jeweils ein Transistor (70, 71) parallel geschaltet ist, **dadurch gekennzeichnet,** daß die Steuereingänge der parallel geschalteten Transistoren (70, 71) über eine Parallelschaltung zweier gegeneinander geschalteter Inverter (72, 73) mit dem Ausgang (60) der Ausgangsstufe (2) verbunden sind.

2. Elektronische Schaltung nach Anspruch 1, **dadurch gekennzeichnet,** daß die als Gegentaktverstärker ausgebildeten komplementären bipolaren Transistoren (74, 75) der Ausgangsstufe (2) nur während einer Signalflanke aktiv sind.

3. Elektronische Schaltung nach Anspruch 1 oder 2, **dadurch gekennzeichnet,** daß die Eingangsstufe (1) mit zwei komplementären bipolaren Differenzverstärkerstufen (21, 22; 23, 24) gebildet wird, deren Eingänge (31, 32) die Eingangssignale gleichzeitig zugeführt werden, und die Ansteuerung der die Ausgangsstufe (2) bildenden Transistoren (74, 75) direkt durch den in diesen Differenzverstärkern umgeschalteten Strom erfolgt.

4. Elektronische Schaltung nach Anspruch 3, **dadurch gekennzeichnet**, daß die Differenzverstärkerstufen (21, 22; 23, 24) jeweils von einer Stromquelle (51; 52) gespeist werden, wobei die jeweilige Stromquelle (51, 52) der im jeweils gültigen logischen Zustand nicht benutzten Eingangsdifferenzverstärkerstufe (21, 22; 23, 24) durch eine Rückkopplung vom Ausgang (60) der Ausgangsstufe (2) abgeschaltet wird.

## Claims

1. Electronic circuit for amplifying digital signals with a small level swing, customary in emitter-coupled transistor logic, to a large level swing, customary in CMOS logic, having an input stage (1) designed as a differential amplifier, the inputs (31, 32) of which are fed by the digital signals with the small level swing, to be amplified to the large level swing, and having an output stage (2), which is driven by the input stage (1) and being formed as a push-pull amplifier by means of complementary bipolar transistors (74, 75) and at the output (60) of which the digital signal amplified to the large level swing can be picked up, wherein the base-terminals of the complementary bipolar transistors (74, 75) form control inputs of the output stage (2) and at least one of said transistors (75) is directly driven by the current switched-over by said input differential amplifier stage (1) and wherein in each case a transistor (70, 71) is connected in parallel to both complementary bipolar transistors (74, 75), characterized in that the control inputs of the parallel-connected transistors (70, 71) are connected to the output (60) of the output stage (2) via a parallel circuit of two inverters (72, 73) connected in opposition.

2. Electronic circuit according to claim 1, characterized in that the complementary bipolar transistors (74, 75) in form of a push-pull amplifier of the output stage (2) are active only during a signal edge.

3. Electronic circuit according to claim 1 or 2, characterized in that said input stage (1) is formed by two complementary bipolar differential amplifier stages (21, 22; 23, 24), whose inputs (31, 32) are fed by the input signals simultaneously and that the driving of the transistors (74, 75) forming the output stage (2) is performed directly by the current switched-over in said differential amplifiers.

4. Electronic circuit according to claim 3, characterized in that the differential amplifier stages (21, 22; 23, 24) each are fed by a current source (51; 52), wherein the respective current source (51, 52) of the input difference amplifier stage (21, 22; 23, 24) not being used in the respective valid logic status is switched off by a feedback from the output (60) of the output stage (2).

## Revendications

1. Circuit électronique d'amplification des signaux numériques présentant un passage de niveau logique réduitqui correspond au circuit de logique TTL à couplage d'émetteur en un passage usuel important dans la logique CMOS, avec un étage d'entrée (1) réalisé en tant qu'amplificateur différenciateur, les signaux numériques à amplifier à un passage de niveau important sont acheminés avec le petit passage de niveau aux entrées de commande, avec un étage de sortie (2) commandé par l'étage d'entrée au moyen de transistors bipolaires complémentaires (74, 75), réalisé en tant qu'amplificateur symétrique, le signal numérique amplifié au passage de niveau important peut être réduit à sa sortie, où les bornes de base des transistors bipolaires complémentaires (74, 75) constituent les entrées de commande de l'étage de sortie (2) et au moins un de ces transistors (75) est commandé directement par le courant commuté par l'étage de l'amplificateur différenciateur d'entrée et où un transistor (70, 71) est monté en parallèle aux intervalles base-émetteur des transistors bipolaires complémentaires (74, 75), **caractérisé en ce que** les entrées de commande des transistors (70, 71) montés en parallèle sont reliées à la sortie (60) de l'étage de sortie, sur une connexion parallèle de deux inverseurs (72, 73) montés côte à côte.

2. Circuit électronique, conforme à la revendication 1, **caractérisé en ce que** les transistors bipolaires complémentaires (74, 75) de l'étage de sortie (2), constitués comme amplificateurs symétriques, ne sont actifs que lors d'une impulsion du signal.

3. Circuit électronique, conforme à la revendication 1 ou 2, **caractérisé en ce que** l'étage d'entrée (1) est constitué de deux étages d'amplificateurs différenciateurs bipolaires complémentaires (21, 22 ; 23, 24), les signaux d'entrée sont acheminés simultanément vers les entrées (31, 32) et la commande des transistors (74, 75) qui constituent l'étage de sortie (2) s'effectue directement par le courant commuté dans ces amplificateurs différenciateurs.

4. Circuit électronique, conforme à la revendication 3, **caractérisé en ce que** les étages d'amplificateurs différenciateurs (21, 22 ; 23, 24) sont respectivement chargés par une source de courant (51; 52), où la source de courant respective (51, 52) de l'étage d'amplificateurs différenciateurs d'entrée (21, 22 ; 23, 24), utilisé dans l'état logique validé, est déconnectée par une réaction de sortie (60) de l'étage de sortie (60).
